# EUROPÄISCHE PATENTSCHRIFT

(11) **EP 4 016 784 B1**
(45) Veröffentlichungstag und Bekanntmachung des Hinweises auf die Patenterteilung: **04.09.2024**
(21) Anmeldenummer: 20214342.6
(22) Anmeldetag: 15.12.2020
(51) Int. Cl.: H02J 7/00

(54) **LADEGERÄT UND LADEGERÄTGEHÄUSE MIT WASSERABLEITSTRUKTUR**
CHARGER AND CHARGER HOUSING WITH WATER DRAIN STRUCTURE
CHARGEUR ET BOITIER DE CHARGEUR À STRUCTURE D'ÉVACUATION D'EAU

(43) Veröffentlichungstag der Anmeldung: 22.06.2022
(73) Patentinhaber: Andreas Stihl AG & Co. KG, 71336 Waiblingen (DE)
(72) Erfinder: FUCHS, Michael, 71332 Waiblingen (DE); HELLMANN, Charis, 70825 Korntal-Münchingen (DE); LANG, Benedikt, 70374 Stuttgart (DE)
(74) Vertreter: Patentanwälte Ruff, Wilhelm, Beier, Dauster & Partner mbB

(56) Entgegenhaltungen:
- EP-A1- 2 866 324
- EP-B1- 2 824 795
- EP-B1- 2 866 324
- US-A1- 2013 328 523
- US-A1- 2017 294 787
- US-A1- 2019 334 359

## Beschreibung

Die Erfindung bezieht sich auf ein Ladegerätgehäuse nach dem Oberbegriff des Patentanspruchs 1 sowie auf ein mit einem solchen Ladegerätgehäuse ausgerüstetes Ladegerät.

Ein solches Ladegerätgehäuse beinhaltet u.a. eine Bedienseite, mindestens einen von der Bedienseite her zugänglichen Batterieladeplatz, einen ersten Gehäuseaußenwandbereich an einer ersten Gehäuseseite, die in einer ersten Gebrauchslage des Ladegerätgehäuses dessen untenliegende Seite bildet, und eine Wasserableitstruktur zum Ableiten von Wasser aus dem Ladegerätgehäuse, wobei die Wasserableitstruktur mindestens eine erste Wasserauslassöffnung in dem ersten Gehäuseaußenwandbereich aufweist.

Derartige Ladegerätgehäuse werden für Ladegeräte, genauer gesagt elektrische Ladegeräte, verwendet, die zum Laden, i.e. elektrischen Aufladen, einer jeweiligen wiederaufladbaren elektrischen Batterieeinheit dienen. Dazu wird die betreffende Batterieeinheit von der Bedienseite des Ladegerätgehäuses her in den Batterieladeplatz eingebracht. Aus diesem kann sie dann wieder an der Bedienseite des Ladegerätgehäuses entnommen werden, insbesondere nach erfolgter Aufladung. Das Ladegerät kann als Einzelplatzladegerät, das einen einzigen Batterieladeplatz aufweist, oder als Mehrplatzladegerät ausgeführt sein, das über mehrere Batterieladeplätze verfügt. Der Begriff Batterieeinheit umfasst vorliegend einen elektrischen Energiespeicher jedweden herkömmlichen Batterietyps, insbesondere vom Typ sogenannter Akkupacks, wie sie zur elektrischen Energieversorgung beispielsweise von elektrisch betriebenen Garten- und Forstbearbeitungsgeräten sowie elektrisch betriebenen Heimwerkergeräten vielfach zum Einsatz kommen.

Für den Betrieb des Ladegerätes wird es mit seinem Ladegerätgehäuse in Gebrauchslage gebracht, d.h. in eine räumliche Lage, in der das Ladegerät bestimmungsgemäß betrieben werden kann, was u.a. bedingt, dass die Bedienseite für den Benutzer zugänglich ist, um eine Batterieeinheit in den Batterieladeplatz einzubringen oder aus diesem zu entnehmen. Die Gebrauchslage kann beispielsweise darin bestehen, dass das Ladegerätgehäuse mit einer zugehörigen Gehäuseseite auf einer im Wesentlichen horizontalen Unterlage, wie einem Tisch, einem Fußboden in einem Gebäude oder auf dem Erdboden im Freien, abgestellt und bei Bedarf fixiert ist, d.h. die betreffende Gehäuseseite des Ladegerätgehäuses oder genauer gesagt ein auf dieser Gehäuseseite liegende Bereich einer Außenwand des Ladegerätgehäuses kontaktiert die Unterlage bzw. ist dieser zugewandt. Alternativ kann das Ladegerätgehäuse als Gebrauchslage an einer im Wesentlichen vertikalen Wand z.B. eines Gebäudes oder eines Fahrzeugs festgelegt sein, wobei in diesem Fall das Ladegerätgehäuse mit der gleichen Gehäuseseite bzw. dem gleichen Gehäuseaußenwandbereich, mit der bzw. mit dem es im anderen Fall der horizontalen Unterlage zugewandt ist, oder alternativ mit einer ihrer anderen Gehäuseseiten bzw. mit einem anderen, auf dieser anderen Gehäuseseite befindlichen Bereich der Gehäuseaußenwand der vertikalen Wand zugewandt ist. Oftmals ist es auch möglich, das Ladegerätgehäuse dadurch in zwei oder noch mehr unterschiedlichen Gebrauchslagen zu verwenden, dass es wahlweise mit je einer von mehreren Gehäuseseiten bzw. dem jeweiligen Gehäuseaußenwandbereich auf einer horizontalen Unterlage abgestellt wird.

Die Wasserableitstruktur dient dazu, eventuell in das Ladegerätgehäuse eingedrungenes oder im Ladegerätgehäuse entstandenes Wasser, wie Kondenswasser, aus dem Ladegerätgehäuse abzuführen, um zu verhindern, dass übermäßig viel Wasser im Ladegerätgehäuse verbleibt und dort zu Schädigungen führt oder elektrische Kurzschlüsse verursacht. Unter dem Begriff Wasserauslassöffnung ist hierbei vorliegend allgemein jedwede Öffnung beliebiger Form und Abmessung zu verstehen, die das Hindurchführen von Wasser durch die dergestalt gebildete Öffnung hindurch und aus dem Ladegehäuse heraus ermöglicht. Es kann sich insbesondere um eine Bohrung oder eine beliebige andere Durchbrechung durch den entsprechenden Gehäuseaußenwandbereich hindurch oder um einen Spalt zwischen zwei typischerweise eng benachbarten Gehäuseaußenwandabschnitten handeln.

Dazu ist es für herkömmliche Ladegerätgehäuse bekannt, Wasserauslassöffnungen in eine Bodenseite, d.h. Bodenwand, des Ladegerätgehäuses einzubringen, wobei die Bodenseite die in der Gebrauchslage des Ladegerätgehäuses untenliegende Seite des Ladegerätgehäuses bildet, d.h. das Ladegerätgehäuse wird normalerweise mit seiner Bodenseite nach unten auf einer horizontalen Unterlage abgestellt, wenn das zugehörige Ladegerät betrieben werden soll. Derartige herkömmliche Ladegerätgehäuse sind beispielsweise in den Offenlegungsschriften EP 1 315 266 A2, DE 10 2015 002 313 A1, JP 2011-200072 A und JP 2009-178011 A sowie der Patentschrift EP 2 824 795 B1 offenbart.

Ladegerätgehäuse mit mehreren Wasserauslassöffnungen sind z.B. in den Offenlegungsschriften US 2013/0328523 A1, EP 2 866 324 A1 und US 2017/0294787 A1 offenbart.

Die Offenlegungsschrift US 2019/0334359 A1 offenbart ein Ladegerätgehäuse nach dem Oberbegriff des Anspruchs 1, das eine gebäudeartige Form mit einem quaderförmigen Grundkörper, der eine Bodenwand, eine Vorderwand, eine Rückwand und zwei gegenüberliegende Seitenwände umfasst, und einem die Bedienseite bildenden, dreieckförmigen Dachteil besitzt und das mit einer dem Dachteil entgegengesetzten Bodenwand des Grundkörpers wahlweise auf einer horizontalen Unterlage abgestellt oder an einer vertikalen Wand befestigt werden kann. Die Wände des Grundkörpers sind sämtlich plan ausgeführt. Die Bodenwand und die bei Wandbefestigung unten liegende Seite des Grundkörpers sind mit Wasserauslassöffnungen versehen.

Der Erfindung liegt als technisches Problem die Bereitstellung eines Ladegerätgehäuse der eingangs genannten Art, das sich mit vergleichsweise geringem Aufwand realisieren lässt und gegenüber dem oben erwähnten Stand der Technik insbesondere hinsichtlich Gebrauchsvariabilität und Feuchtigkeitsschutz verbessert ist, und eines damit ausgerüsteten Ladegerätes zugrunde.

Die Erfindung löst dieses Problem durch die Bereitstellung eines Ladegerätgehäuses mit den Merkmalen des Anspruchs 1 und eines Ladegerätes mit den Merkmalen des Anspruchs 9. Vorteilhafte Weiterbildungen der Erfindung, die zur Lösung dieses und weiterer Probleme beitragen, sind in den Unteransprüchen angegeben, deren Inhalt einschließlich sämtlicher sich durch die Anspruchsrückbezüge ergebender Merkmalskombinationen hiermit vollumfänglich durch Verweis zum Inhalt der Beschreibung gemacht wird.

Das erfindungsgemäße Ladegerätgehäuse umfasst einen zweiten Gehäuseaußenwandbereich an einer zur ersten nicht-parallelen zweiten Gehäuseseite, die in einer zweiten Gebrauchslage des Ladegerätgehäuses dessen untenliegende Seite bildet, wobei die Wasserableitstruktur mindestens eine zweite Wasserauslassöffnung in dem zweiten Gehäuseaußenwandbereich beinhaltet.

Durch diese Charakteristik kann das Ladegerätgehäuse in mindestens zwei unterschiedlichen Gebrauchslagen verwendet werden, wobei in jeder dieser Gebrauchslagen die jeweils untenliegende Gehäuseseite, genauer gesagt der auf dieser Seite befindliche Bereich einer Außenwand des Ladegerätgehäuses, eine oder mehrere Wasserauslassöffnungen aufweist. Dadurch ist in jeder dieser unterschiedlichen Gebrauchslagen, d.h. Lageorientierungen des Ladegerätgehäuses im Raum, beim Gebrauch des Ladegerätes im Betrieb zum Laden einer oder gleichzeitig mehrerer wiederaufladbarer Batterieeinheiten dafür gesorgt, dass im Gehäuse gebildetes und/oder in das Gehäuse eingedrungenes Wasser aus dem Gehäuse austreten kann und nicht im Gehäuse verbleibt.

Das Ladegerätgehäuse lässt sich dadurch sehr variabel und flexibel einsetzen, z.B. durch Abstellen auf einer im Wesentlichen horizontalen Unterlage und optionales Fixieren an selbiger und/oder durch Anbringen an einer im Wesentlichen vertikalen Wand, wobei sich in jeder von mehreren solcher unterschiedlicher Gebrauchslagen eine oder mehrere Wasserauslassöffnungen an der jeweils untenliegenden Gehäuseseite befinden, so dass Wasser aus dem Gehäuse unterseitig austreten kann.

Gemäß einem Aspekt der Erfindung verläuft der erste Gehäuseaußenwandbereich von einem erhabenen ersten Mittenbereich zu mindestens einem tieferliegenden ersten Seitenrandbereich hin, bevorzugt zu zwei gegenüberliegenden ersten Seitenrandbereichen hin, konkav abfallend und beinhaltet mindestens eine der einen oder mehreren ersten Wasserauslassöffnungen in diesem tieferliegenden ersten Seitenrandbereich. Diese Gestaltung der betreffenden Gehäuseseite unterstützt das Abführen von Wasser aus dem Gehäuse, wenn sich das Ladegerätgehäuse in seiner ersten Gebrauchslage befindet. Denn diese erste Wasserauslassöffnung liegt dann an einem quasi tiefsten Punkt bzw. Niveau des Gehäuses, und Wasser kann gefällebedingt vom höheren ersten Mittenbereich zu dem oder den tieferen ersten Seitenrandbereichen abfließen und über die eine oder mehreren dortigen ersten Wasserauslassöffnungen aus dem Gehäuse austreten. Auf diese Weise bildet der entsprechende Teil des ersten Gehäuseaußenwandbereichs einen wasserleitenden Gehäuseflächenteil der Wasserableitstruktur.

Gemäß einem weiteren, zusätzlich oder alternativ zum vorgenannten Aspekt realisierbaren Aspekt der Erfindung verläuft der zweite Gehäuseaußenwandbereich von mindestens einem erhabenen zweiten Seitenrandbereich, vorzugsweise von zwei entgegengesetzten erhabenen zweiten Seitenrandbereichen, zu einem tieferliegenden zweiten Mittenbereich hin konvex abfallend, und mindestens eine der einen oder mehreren zweiten Wasserauslassöffnungen ist in den tieferliegenden zweiten Mittenbereich eingebracht. Diese Formgestaltung der zweiten Gehäuseseite in Kombination mit dem Einbringen der zweiten Wasserauslassöffnung in den Mittenbereich dieser Gehäuseseite begünstigt das Abführen von Wasser aus dem Ladegerätgehäuse, wenn sich letzteres in seiner zweiten Gebrauchslage befindet, indem sich diese zweite Wasserauslassöffnung dann an einer quasi tiefsten Stelle des Ladegerätgehäuses befindet. In alternativen Ausführungen verläuft die zweite Gehäuseseite z.B. im Wesentlichen plan, d.h. mit einem in etwa auf gleichem Höhenniveau wie die zweiten Seitenrandbereiche liegenden zweiten Mittenbereich.

Das erfindungsgemäße Ladegerät weist ein derartiges, erfindungsgemäßes Ladegerätgehäuse auf.

In einer Weiterbildung der Erfindung weist der mindestens eine erste Seitenrandbereich einen gegenüber einem angrenzenden, tieferliegenden Wandabschnitt erhabenen Wandabschnitt auf, und mindestens eine der einen oder mehreren in diesem ersten Seitenrandbereich gelegenen ersten Wasserauslassöffnungen ist in einen den tieferliegenden Wandabschnitt mit dem erhabenen Wandabschnitt verbindenden Wandabschnitt des Ladegerätgehäuses eingebracht. Durch diese Maßnahme ist die betreffende Wasserauslassöffnung relativ gut gegen ein unabsichtliches Einbringen von Schmutz geschützt, da sie nicht direkt nach unten aus der in der zugehörigen Gebrauchslage des Gehäuses untenliegenden, ersten Gehäuseseite mündet, sondern quer dazu im Wandabschnitt, der den tieferen mit dem erhabenen Wandabschnitt verbindet und der dadurch beispielsweise im Wesentlichen in einer vertikalen Ebene liegen kann, wenn der erste Gehäuseaußenwandbereich im Wesentlichen horizontal orientiert ist. In alternativen Ausführungen ist die jeweilige erste Wasserauslassöffnung z.B. in den tieferen Wandabschnitt eingebracht.

In einer Weiterbildung der Erfindung weist der mindestens eine erste Seitenrandbereich eine Griffmuldenzone mit einem erhabenen Griffzonenabschnitt und einem demgegenüber tieferliegenden Griffzonenabschnitt auf, und mindestens eine der einen oder mehreren, in diesem ersten Seitenrandbereich gelegenen ersten Wasserauslassöffnungen ist in den tieferliegenden Griffzonenabschnitt eingebracht. Diese Maßnahme kombiniert vorteilhaft eine Grifffunktion für den betreffenden ersten Seitenrandbereich mit dem Anordnen einer oder mehrerer der ersten Wasserauslassöffnungen im entsprechenden Griffbereich, d.h. die Formgestaltung des ersten Seitenrandbereichs zur Bereitstellung der Griffmuldenzone wird gleichzeitig dafür genutzt, dort in geeigneter Weise die mindestens eine erste Wasserauslassöffnung einzubringen. In alternativen Ausführungen befindet sich die mindestens eine erste Wasserauslassöffnung nicht im tieferen Griffzonenabschnitt, sondern beispielsweise im erhabenen Griffzonenabschnitt oder außerhalb der Griffmuldenzone des betreffenden ersten Seitenrandbereichs.

In einer Weiterbildung der Erfindung weist der Batterieladeplatz ein zur Bedienseite hin offenes Batterieschachtgehäuse auf, und die Wasserableitstruktur beinhaltet mindestens eine dritte Wasserauslassöffnung, die aus dem Batterieschachtgehäuse herausführt. Diese Maßnahme erleichtert ein Abführen von Wasser, das in das Batterieschachtgehäuse z.B. von der Bedienseite her eingedrungen ist oder sich als Kondenswasser im Batterieschachtgehäuse gebildet hat, aus dem Batterieschachtgehäuse heraus.

In einer Ausgestaltung der Erfindung mündet mindestens eine der einen oder mehreren dritten Wasserauslassöffnungen aus einer der Bedienseite entgegengesetzten Gehäuseseite des Batterieschachtgehäuses in einen Gehäuseinnenraum zwischen dem Batterieschachtgehäuse und dem ersten oder dem zweiten Gehäuseaußenwandbereich oder direkt in eine zugeordnete der einen oder mehreren ersten oder zweiten Wasserauslassöffnungen. Dies ermöglicht ein entsprechendes Abführen von Wasser aus dem Batterieschachtgehäuse an dessen der Bedienseite entgegengesetzten Gehäuseseite und aus dem Ladegerätgehäuse insgesamt heraus nach außen, letzteres entweder über einen dortigen Teil des zugehörigen Gehäuseaußenwandbereichs als Bestandteil der Wasserableitstruktur oder direkt über die zugeordnete mindestens eine erste oder zweite Wasserauslassöffnung im ersten bzw. zweiten Gehäuseaußenwandbereich des Ladegerätgehäuses. In Fällen, in denen sich das Ladegerätgehäuse in einer Gebrauchslage mit obenliegender Bedienseite befindet, kann das Wasser über diese dann auf der untenliegenden Seite des Batterieladeplatzes befindliche dritte Wasserauslassöffnung besonders leicht aus dem Batterieschachtgehäuse austreten. In alternativen Ausführungen befindet sich die dritte Wasserauslassöffnung z.B. an einer der Bedienseite benachbarten Gehäuseseite des Batterieschachtgehäuses.

In einer Weiterbildung der Erfindung umfasst das Ladegerätgehäuse eine zweiteilige Gehäuseschale mit einer Bodengehäuseschale und einer mit dieser umlaufend verbundenen Deckelgehäuseschale, wobei mindestens eine der einen oder mehreren zweiten Wasserauslassöffnungen in dem zweiten Gehäuseaußenwandbereich eine Spaltöffnung zwischen den beiden Gehäuseschalen beinhaltet. Diese Maßnahme kombiniert vorteilhaft einen Schalenaufbau des Ladegerätgehäuses mit der Bildung dieser zweiten Wasserauslassöffnung als Spaltöffnung zwischen den Gehäuseschalen. In alternativen Ausführungen sind die beiden Gehäuseschalen an der zweiten Gehäuseseite fluiddicht miteinander verbunden, und die zweite Wasserauslassöffnung ist als Durchbrechung in der einen und/oder der anderen Gehäuseschale gebildet. In vorteilhaften Ausführungen befindet sich die Bedienseite an der Deckelgehäuseschale, alternativ an der Bodengehäuseschale.

In einer Ausgestaltung der Erfindung sind mehrere zweite Wasserauslassöffnungen in dem zweiten Gehäuseaußenwandbereich als jeweilige Spaltöffnung zwischen den beiden Gehäuseschalen und mit Abstand voneinander entlang einer Trennlinie der beiden Gehäuseschalen gebildet. Diese Maßnahme fördert ein zuverlässiges Abführen von Wasser aus dem Ladegerätgehäuse an mehreren Stellen längs der vorzugsweise umlaufenden Trennline der beiden Gehäuseschalen an der zweiten Gehäuseseite, wenn sich das Ladegerätgehäuse in seiner zweiten Gebrauchslage befindet. Dabei kann sich z.B. in der Realisierung mit tieferliegendem zweitem Mittenbereich jeweils mindestens eine zweite Wasserauslassöffnung im und außerhalb des zweiten Mittenbereichs befinden.

In einer Weiterbildung der Erfindung ist das Ladegerätgehäuse quaderförmig, wobei eine erste Quaderseite die Bedienseite bildet, eine der ersten gegenüberliegende zweite Quaderseite die erste Gehäuseseite mit der oder den ersten Wasserauslassöffnungen bildet und eine dritte Quaderseite zwischen der ersten und der zweiten Quaderseite die zweite Gehäuseseite mit der oder den zweiten Wasserauslassöffnungen bildet. Dies stellt eine für viele Anwendungen günstige Formgestaltung des Ladegerätgehäuses dar, wobei der so gebildete Gehäusequader sehr variabel einsetzbar ist. Während die erste Quaderseite als Bedienseite zum Einbringen von elektrisch aufzuladenden Batterieeinheiten und Herausnehmen geladener Batterieeinheiten fungiert, kann das quaderförmige Gehäuse wahlweise mit seiner gegenüberliegenden Quaderseite oder einer zwischenliegenden Quaderseite auf einer horizontalen Unterlage abgestellt bzw. befestigt oder an einer vertikalen Wand befestigt werden.

In alternativen Ausführungen ist das Ladegerätgehäuse von anderer Form, z.B. pyramidenförmig oder prismenförmig.

Vorteilhafte Ausführungsformen der Erfindung sind in den Zeichnungen dargestellt. Diese und weitere Ausführungsformen der Erfindung werden nachfolgend näher erläutert. Hierbei zeigen:
- Fig. 1: eine Perspektivansicht eines Ladegeräts schräg von oben mit einem Ladegerätgehäuse in einer ersten Gebrauchslage auf einer im Wesentlichen horizontalen Unterlage,
- Fig. 2: eine Perspektivansicht des Ladegeräts schräg von unten,
- Fig. 3: eine Perspektivansicht einer Bodengehäuseschale des Ladegerätgehäuses,
- Fig. 4: eine Detailansicht eines Bereichs IV von Fig. 3,
- Fig. 5: eine Längsschnittansicht durch ein Batterieschachtgehäuse des Ladegerätgehäuses,
- Fig. 6: eine Draufsicht auf das Batterieschachtgehäuse von einer Bedienseite des Ladegerätgehäuses her,
- Fig. 7: eine Perspektivansicht schräg von oben auf das Ladegerät in einer zweiten Gebrauchslage auf einer im Wesentlichen horizontalen Unterlage,
- Fig. 8: eine Schnittansicht des Ladegerätgehäuses in der zweiten Gebrauchslage in einer Längsmittenebene des Ladegerätgehäuses,
- Fig. 9: eine Perspektivansicht schräg von oben auf die Bodengehäuseschale des Ladegerätgehäuses,
- Fig. 10: eine Detailansicht eines Bereichs X von Fig. 9 und
- Fig. 11: eine Detailansicht eines Bereichs XI von Fig. 10.

Das erfindungsgemäße Ladegerät, wie es in einer beispielhaften Realisierung gezeigt ist, dient in an sich bekannter Weise zum elektrischen Laden einer wiederaufladbaren Batterieeinheit, wobei es sich bei der Batterieeinheit insbesondere um einen Akkupack zur elektrischen Energieversorgung eines elektrisch betriebenen Garten- und Forstbearbeitungsgeräts oder eines elektrisch betriebenen Heimwerkergeräts handeln kann.

Das Ladegerät beinhaltet ein Ladegerätgehäuse mit einer Bedienseite 1 und mindestens einem von der Bedienseite 1 her zugänglichen Batterieladeplatz 2. Im gezeigten Beispiel besitzt das Ladegerätgehäuse vier Batterieladeplätze 2, in denen jeweils ein wiederaufladbarer Akkupack 16 zum elektrischen Laden durch das Ladegerät aufgenommen werden kann. Über ein Netzkabel 18 kann das Ladegerät an eine elektrische Stromversorgung angeschlossen werden.

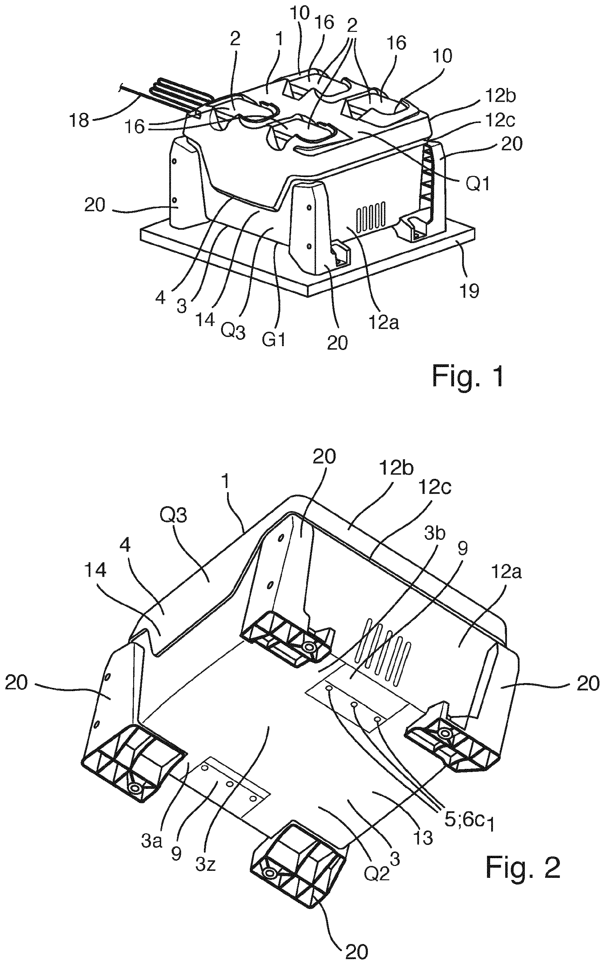

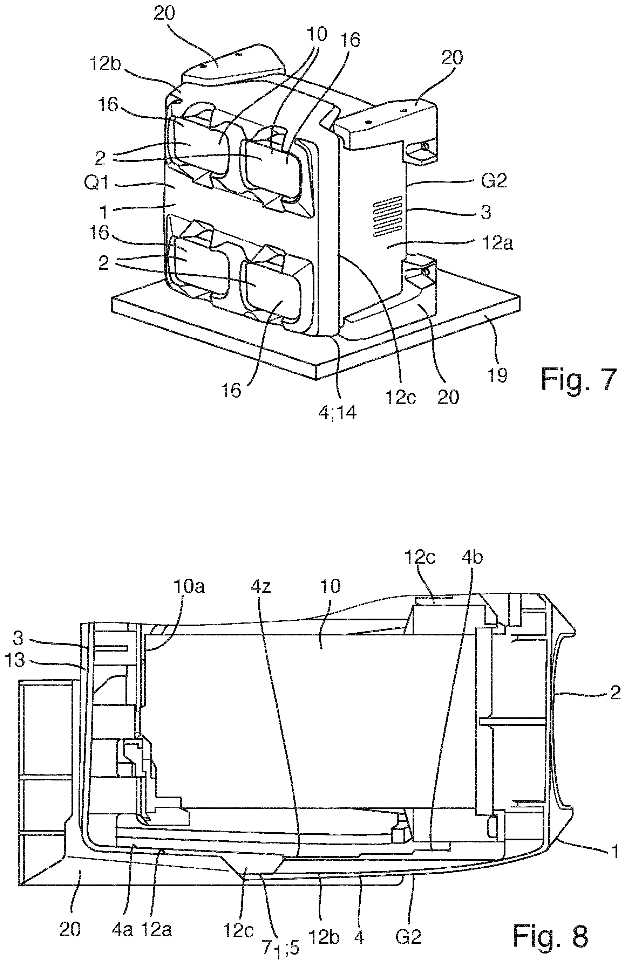

Das Ladegerätgehäuse besitzt des Weiteren einen ersten Gehäuseaußenwandbereich 13 an einer ersten Gehäuseseite 3, die in einer ersten, in Fig. 1 gezeigten Gebrauchslage G1 des Ladegerätgehäuses eine untenliegende Seite des Ladegerätgehäuses bildet, und einen zweiten Gehäuseaußenwandbereich 14 an einer zur ersten nicht-parallelen zweiten Gehäuseseite 4, die in einer zweiten, in Fig. 7 gezeigten Gebrauchslage G2 des Ladegerätgehäuses eine untenliegende Seite des Ladegerätgehäuses bildet. Speziell verläuft im gezeigten Beispiel die zweite Gehäuseseite 4 etwa senkrecht zur ersten Gehäuseseite 3, d.h. das Ladegerätgehäuse ist in der zweiten Gebrauchslage G2 um etwa 90° gegenüber seiner ersten Gebrauchslage G1 gekippt orientiert. Dabei sind die beiden Gehäuseseiten 3, 4 bzw. deren Gehäuseaußenwandbereiche 13, 14 im gezeigten Beispiel als im Wesentlichen ebenmäßige Seitenflächen des Ladegerätgehäuses gebildet, wobei je nach Bedarf profilierte Wandstrukturteile z.B. in Form vorstehender und/oder zurückgesetzter Wandteile vorhanden sein können.

In den Fig. 1 und 7 ist das Ladegerätgehäuse jeweils auf einer in etwa horizontalen Unterlage 19 aufliegend gezeigt. In alternativen Platzierungen kann das Ladegerätgehäuse in jeder der beiden Gebrauchslagen G1, G2 an einer im Wesentlichen vertikal orientierten Wand z.B. eines Gebäudes oder eines Fahrzeugs gehalten sein. Zum Fixieren des Ladegerätgehäuses in seiner jeweiligen Gebrauchslage G1, G2 auf der horizontalen Unterlage 19 oder einer anders orientierten Unterlage bzw. Wand ist das Ladegerätgehäuse mit geeigneten Befestigungsstützen 20 versehen, die entsprechende Befestigungselemente aufweisen, wie an geeigneten Stellen angeordnete Schrauböffnungen.

Des Weiteren beinhaltet das Ladegerätgehäuse eine Wasserableitstruktur 5 zum Ableiten von Wasser aus dem Ladegerätgehäuse, wobei die Wasserableitstruktur 5 mindestens eine erste Wasserauslassöffnung 6a₁ in dem ersten Gehäuseaußenwandbereich 13 und mindestens eine zweite Wasserauslassöffnung 7₁ in dem zweiten Gehäuseaußenwandbereich 14 umfasst. Optional beinhaltet die Wasserableitstruktur 5 zusätzlich wasserleitende Formungsabschnitte und/oder Gehäusewandstrukturen an der Innenseite des ersten und/oder des zweiten Gehäuseaußenwandbereichs 13, 14, um Wasser von entfernten Stellen im Inneren des Ladegerätgehäuses zu einer der Wasserauslassöffnungen 6a₁, 7₁ im ersten bzw. zweiten Gehäuseaußenwandbereich 13, 14 führen bzw. ableiten zu können. Über die mindestens eine erste bzw. die mindestens eine zweite Wasserauslassöffnung 6a₁, 7₁ kann Wasser, das in das Gehäuseinnere eingedrungen ist oder sich dort gebildet hat, aus dem Ladegerätgehäuse nach außen austreten, wenn sich das Ladegerätgehäuse in der ersten bzw. zweiten Gebrauchslage G1, G2 befindet, da sich die Wasserauslassöffnungen 6a₁, 7₁ im jeweils zugehörigen, in der betreffenden Gebrauchslage G1, G2 des Ladegerätgehäuses untenliegenden, ersten bzw. zweiten Gehäuseaußenwandbereich 13, 14 befinden, der auf der betreffenden Gehäuseseite 3, 4 einen außenliegenden Wandbereich des Ladegerätgehäuses bildet.

In entsprechenden Ausführungen weist die Wasserableitstruktur 5, wie beim ggezeigten Beispiel, eine Mehrzahl erster Wasserauslassöffnungen 6a₁, 6a₂, 6b₁, 6b₂, 6c₁, 6d₁ im ersten Gehäuseaußenwandbereich 13 und/oder eine Mehrzahl zweiter Wasserauslassöffnungen 7₁, 7₂, 7₃ im zweiten Gehäuseaußenwandbereich 14 auf. In alternativen Ausführungen ist nur jeweils eine Wasserauslassöffnung im ersten und/oder im zweiten Gehäuseaußenwandbereich 13, 14 vorgesehen.

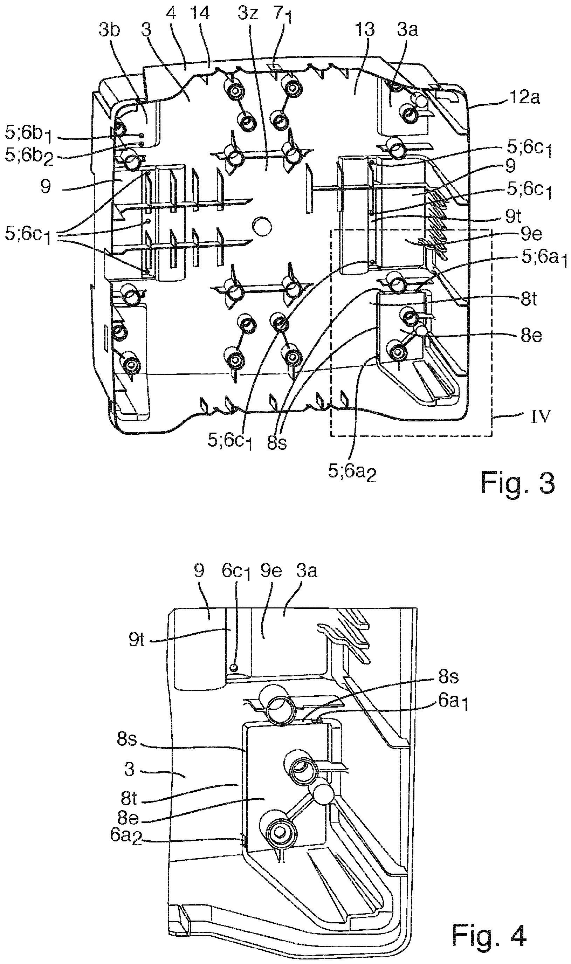

In entsprechenden Ausführungsformen verläuft, wie im gezeigten Beispiel, der erste Gehäuseaußenwandbereich 13 von einem erhabenen ersten Mittenbereich 3z zu mindestens einem tieferliegenden ersten Seitenrandbereich 3a hin konkav abfallend, im gezeigten Beispiel zu zwei entgegengesetzten ersten Seitenrandbereichen 3a, 3b hin, wie anhand der Fig. 2 und 3 ersichtlich. Unter der Charakterisierung erhaben ist hierbei zu verstehen, dass der erste Mittenbereich 3z auf einem höheren Niveau als die ersten Seitenrandbereiche 3a, 3b liegt, wenn sich das Ladegerätgehäuse in seiner zugehörigen ersten Gebrauchslage G1 befindet. Die Wasserableitstruktur 5 beinhaltet im jeweiligen tieferliegenden ersten Seitenrandbereich 3a, 3b mindestens eine erste Wasserauslassöffnung 6a₁, 6b₁. Im gezeigten Beispiel sind es jeweils mehrere erste Wasserauslassöffnungen 6a₁, 6a₂ bzw. 6b₁, 6b₂ in jedem der zwei ersten Seitenrandbereiche 3a, 3b, wie beispielsweise aus Fig. 3 ersichtlich. Dadurch kann Wasser aufgrund des vorliegenden Gefälles problemlos vom erhabenen ersten Mittenbereich 3z zu dem oder den tieferliegenden Seitenrandbereichen 3a, 3b hin und damit zu der oder den dort befindlichen ersten Wasserauslassöffnungen 6a₁, 6a₂, 6b₁, 6b₂ hin abfließen, d.h. der erste Gehäuseaußenwandbereich 13 bildet mit seinem abfallenden Wandverlauf vom erhabenen ersten Mittenbereich 3z zu den tieferliegenden Seitenrandbereichen 3a, 3b einen Wandstrukturteil der Wasserableitstruktur 5.

In einer speziellen Realisierung weist mindestens ein erster Seitenrandbereich 3a, im gezeigten Beispiel beide erste Seitenrandbereiche 3a, 3b, einen gegenüber einem angrenzenden, tieferliegenden Wandabschnitt 8t erhabenen Wandabschnitt 8e auf, und die mindestens eine erste Wasserauslassöffnung 6a₁, im gezeigten Beispiel die ersten Wasserauslassöffnungen 6a₁, 6a₂, 6b₁ und 6b₂, ist in einen den tieferliegenden Wandabschnitt 8t mit dem erhabenen Wandabschnitt 8e verbindenden Wandabschnitt 8s eingebracht, wie speziell aus den Fig. 3 und 4 ersichtlich. Da der Wandabschnitt 8s zwischen den auf unterschiedlichem Höhenniveau liegenden Wandabschnitten 8t und 8e vermittelt, ist er mit seiner Wandfläche in der Regel im Wesentlichen vertikal orientiert, wenn sich das Ladegerätgehäuse in der zugehörigen ersten Gebrauchslage G1 auf der im Wesentlichen horizontalen Unterlage 19 befindet und an diese mit seiner ersten Gehäuseseite 3 angrenzt. Dies kann die dort eingebrachte oder eingebrachten ersten Wasserauslassöffnungen 6a₁, 6a₂, 6b₁, 6b₂ gegen von unten eindringenden Schmutz schützen.

In entsprechenden Ausführungsformen des Ladegerätgehäuses weist mindestens ein erster Seitenrandbereich 3a, im gezeigten Beispiel beide erste Seitenrandbereiche 3a, 3b, des ersten Gehäuseaußenwandbereichs 13 eine Griffmuldenzone 9 mit einem erhabenen Griffzonenabschnitt 9e und einem demgegenüber tieferliegenden Griffzonenabschnitt 9t auf, und mindestens eine erste Wasserauslassöffnung 6c₁, im gezeigten Beispiel mehrere erste Wasserauslassöffnungen 6c₁, ist in den tieferliegenden Griffzonenabschnitt 9t eingebracht. Dadurch fungiert der betreffende Wandflächenbereich des ersten Gehäuseaußenwandbereichs 13 einerseits als Strukturteil zur Bildung der Griffmuldenzone 9, die dem Benutzer das Greifen und Handhaben des Ladegerätgehäuses erleichtert, und andererseits als wasserableitender Strukturteil der Wasserableitstruktur 5, indem dort Wasser vom erhabenen Griffzonenabschnitt 9e zum tieferliegenden Griffzonenabschnitt 9t abfließen und über die jeweilige dortige erste Wasserauslassöffnung 6c₁ aus dem Ladegerätgehäuse austreten kann.

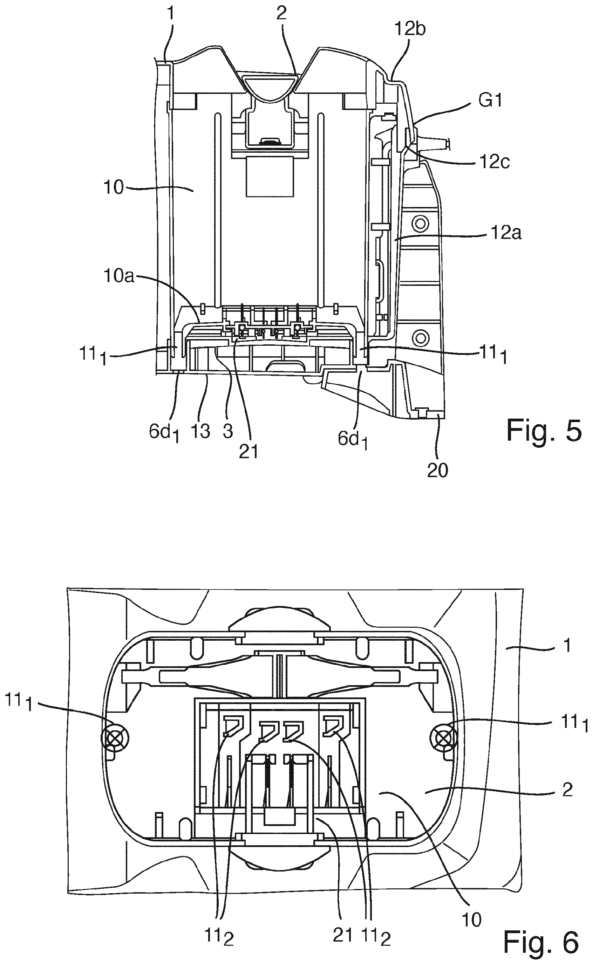

In entsprechenden Ausführungsformen weist der jeweilige Batterieladeplatz 2, wie im gezeigten Beispiel, ein zur Bedienseite 1 hin offenes Batterieschachtgehäuse 10 auf, und die Wasserableitstruktur 5 beinhaltet mindestens eine dritte Wasserauslassöffnung 11₁, die aus dem Batterieschachtgehäuse 10 herausführt, im gezeigten Beispiel mehrere dritte Wasserauslassöffnungen 11₁, 11₂, wie insbesondere aus den Fig. 5 und 6 ersichtlich. Dadurch kann Wasser, das z.B. über die Bedienseite 1 in das Batterieschachtgehäuse 10 eingedrungen ist oder sich als Kondenswasser im Batterieschachtgehäuse 10 gebildet hat, aus dem Batterieschachtgehäuse 10 abfließen. Dazu kann es von Vorteil sein, wenn sich die mindestens eine dritte Wasserauslassöffnung 11₁ an einer dem ersten Gehäuseaußenwandbereich 13 zugewandten Seite des Batterieschachtgehäuses 10 und/oder an einer dem zweiten Gehäuseaußenwandbereich 14 des Ladegerätgehäuses zugewandten Seite des Batterieschachtgehäuses 10 befindet, so dass die betreffende Seite des Batterieschachtgehäuses 10 eine in der zugehörigen ersten bzw. zweiten Gebrauchslage G1, G2 des Ladegerätgehäuses untenliegende Schachtgehäuseseite bildet. Die Fig. 5 und 6 zeigen das Batterieschachtgehäuse 10 im gezeigten Beispiel mit den dritten Wasserauslassöffnungen 11₁, 11₂ auf derjenigen Schachtgehäuseseite, welche die untenliegende Seite des Batterieschachtgehäuses 10 bildet, wenn sich das Ladegerätgehäuse in seiner ersten Gebrauchslage G1 befindet.

In einer vorteilhaften speziellen Realisierung mündet die mindestens eine dritte Wasserauslassöffnung 11₁ aus einer der Bedienseite 1 entgegengesetzten Gehäuseseite 10a des Batterieschachtgehäuses 10 direkt in eine zugeordnete der einen oder mehreren ersten oder zweiten Wasserauslassöffnungen. Im gezeigten Beispiel münden aus dem Batterieschachtgehäuse 10 zwei dritte Wasserauslassöffnungen 11₁ direkt in je eine erste Wasserauslassöffnung 6d₁ an der ersten Gehäuseseite 3. In nicht gezeigten, alternativen Realisierungen mündet mindestens eine dritte Wasserauslassöffnung aus der der Bedienseite 1 entgegengesetzten Gehäuseseite 10a des Batterieschachtgehäuses 10 direkt in eine zugehörige zweite Wasserauslassöffnung im zweiten Gehäuseaußenwandbereich 14.

In einer weiteren vorteilhaften, spezifischen Realisierung mündet mindestens eine dritte Wasserauslassöffnung 11₂ aus der der Bedienseite 1 entgegengesetzten Gehäuseseite 10a des Batterieschachtgehäuses 10 in einen Gehäuseinnenraum 15 zwischen dem Batterieschachtgehäuse 10 einerseits und dem ersten oder dem zweiten Gehäuseaußenwandbereich 13, 14 andererseits. Im gezeigten Beispiel münden mehrere dritte Wasserauslassöffnungen 11₂ durch einen Kontaktzonenbereich 21 an der besagten Gehäuseseite 10a des Batterieschachtgehäuses 10 hindurch in den Gehäuseinnenraum 15 zwischen dem Batterieschachtgehäuse 10 und dem ersten Gehäuseaußenwandbereich 13. Diese dritten Wasserauslassöffnungen 11₂ können z.B. von Kontaktschlitzöffnungen des Kontaktzonenbereichs 21 gebildet sein, wobei der Kontaktzonenbereich 21 in an sich bekannter Weise dazu dient, eine in das Batterieschachtgehäuse 10 eingefügte Batterieeinheit elektrisch mit einem elektrischen Ladeteil des Ladegeräts zu verbinden.

Die Lage der dritten Wasserauslassöffnungen 11₁, 11₂ an der der Bedienseite 1 entgegengesetzten Gehäuseseite 10a des Batterieschachtgehäuses 10 ist besonders dann von Vorteil, wenn sich die Bedienseite 1 des Ladegerätgehäuses in einer entsprechenden Gebrauchslage, im gezeigten Beispiel der ersten Gebrauchslage G1, oben am Ladegerätgehäuse befindet. In diesem Fall kann Wasser, das z.B. von oben über die Bedienseite 1 in das Batterieschachtgehäuse 10 gelangt, an der entgegengesetzten Gehäuseseite 10a wieder nach unten aus dem Batterieschachtgehäuse 10 ausgeleitet werden.

In entsprechenden Ausführungen des Ladegerätgehäuses verläuft der zweite Gehäuseaußenwandbereich 14 von mindestens einem erhabenen zweiten Seitenrandbereich 4a, im gezeigten Beispiel von zwei gegenüberliegenden erhabenen zweiten Seitenrandbereichen 4a, 4b, zu einem tieferliegenden zweiten Mittenbereich 4z hin konvex abfallend, und mindestens eine zweite Wasserauslassöffnung 7₁ befindet sich in dem tieferliegenden zweiten Mittenbereich 4z. Dadurch bildet der zweite Gehäuseaußenwandbereich 14 im betreffenden Teilbereich einen gehäusewandseitigen Strukturteil der Wasserableitstruktur 5, mit dessen Hilfe Wasser von dem oder den höhergelegenen zweiten Seitenrandbereichen 4a, 4b zum tieferliegenden zweiten Mittenbereich 4z geleitet werden kann, um dort über die zweite Wasserauslassöffnung 7₁ aus dem Ladegerätgehäuse herausgeführt zu werden, wenn sich das Ladegerätgehäuse in seiner zweiten Gebrauchslage G2 befindet, wie insbesondere aus Fig. 8 ersichtlich.

In entsprechenden Realisierungen umfasst das Ladegerätgehäuse, wie im gezeigten Beispiel, eine zweiteilige Gehäuseschale mit einer Bodengehäuseschale 12a und einer mit dieser umlaufend verbundenen Deckelgehäuseschale 12b, wobei die mindestens eine zweite Wasserauslassöffnung 7₁ in dem zweiten Gehäuseaußenwandbereich 14 eine Spaltöffnung 17 zwischen den beiden Gehäuseschalen 12a, 12b beinhaltet.

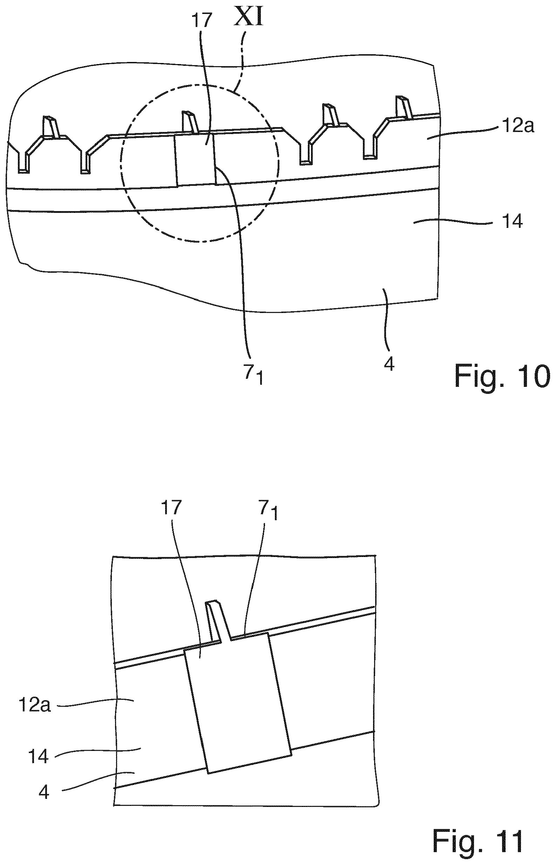

Im gezeigten Beispiel ist die Spaltöffnung 17 von einer außenseitigen Nut im dortigen Wandbereich der Bodengehäuseschale 12a gebildet, wie in den Fig. 10 und 11 zu erkennen. Dieser Nutbereich wird senkrecht zur Wandebene vom dortigen Randbereich der Deckelgehäuseschale 12b überdeckt, so dass die besagte Spaltöffnung 17 zwischen den dortigen Wandabschnitten der beiden Gehäuseschalen 12a, 12b gebildet ist, die ein dortiges Ausleiten von Wasser aus dem Ladegerätgehäuse längs der Spaltöffnung 17 parallel zur Wandungsebene ermöglicht.

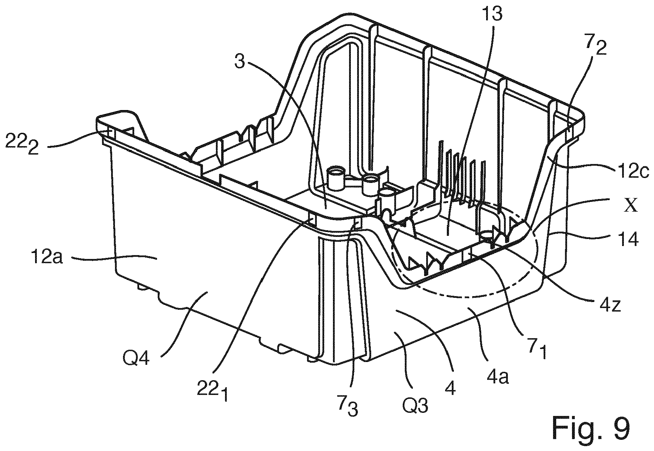

In entsprechenden Realisierungen sind, wie im gezeigten Beispiel, mehrere zweite Wasserauslassöffnungen 7₁, 7₂, 7s als jeweilige Spaltöffnung zwischen den beiden Gehäuseschalen 12a, 12b im zweiten Gehäuseaußenwandbereich 14 und entlang einer Trennlinie 12c der beiden Gehäuseschalen 12a, 12b voneinander beabstandet gebildet. Im gezeigten Beispiel sind eine zweite Wasserauslassöffnung 7₁ im vertieften Mittenbereich 4z und je eine weitere zweite Wasserauslassöffnung 7₂, 7₃ an den beiden Seitenbereichen des zweiten Gehäuseaußenwandbereichs 4 entlang der Trennlinie 12c der beiden Gehäuseschalen 12a, 12b als jeweilige Spaltöffnung gebildet, wie aus Fig. 9 ersichtlich.

In entsprechenden Ausführungen ist das Ladegerätgehäuse, wie beim gezeigten Beispiel, quaderförmig gestaltet, mit einer ersten Quaderseite Q1 als der Bedienseite 1, einer der ersten gegenüberliegenden zweiten Quaderseite Q2 als der ersten Gehäuseseite 3 und einer dritten Quaderseite Q3 zwischen der ersten und der zweiten Quaderseite Q1, Q2 als der zweiten Gehäuseseite 4. Dies stellt eine hinsichtlich Handhabung, Funktionalität und Befestigungsmöglichkeiten günstige Gestaltung des Ladegerätgehäuses dar. Die Bedienseite 1 kann im Gebrauch des Ladegeräts vorteilhaft oben, wie in der ersten Gebrauchslage G1 gemäß Fig. 1, oder vorn, wie in der zweiten Gebrauchslage G2 gemäß Fig. 7, liegen und dadurch optimal zugänglich sein. Gleichzeitig befinden sich Wasserauslassöffnungen der Wasserableitstruktur 5 an günstigen, untenliegenden Stellen des Ladegerätgehäuses, sowohl wenn sich letzteres in seiner ersten Gebrauchslage G1 als auch wenn es sich in seiner zweiten Gebrauchslage G2 befindet.

Je nach Bedarf und Anwendungsfall kann das Ladegerätgehäuse zusätzlich zum ersten und zweiten Gehäuseaußenwandbereich 13, 14, die sich auf der ersten bzw. zweiten Gehäuseseite 3, 4 befinden, einen oder mehrere weitere Gehäuseaußenwandbereiche an einer dritten und eventuell einer oder mehreren weiteren Gehäuseseiten aufweisen, die in entsprechenden weiteren möglichen Gebrauchslagen des Ladegerätgehäuses jeweils dessen untenliegende Seite bilden, wobei die Wasserableitstruktur 5 dann zusätzlich mindestens eine vierte und etwaige weitere, fünfte Wasserauslassöffnungen in jedem dieser weiteren Gehäuseaußenwandbereiche beinhaltet. So kann beispielsweise in entsprechenden Modifikationen des gezeigten quaderförmigen Ladegerätgehäuses eine der dritten Quaderseite Q3 gegenüberliegende Quaderseite und/oder eine der dritten Quaderseite Q3 benachbarte Quaderseite zwischen der ersten und der zweiten Quaderseite Q1, Q2 als eine derartige weitere Gehäuseseite mit entsprechendem weiterem Gehäuseaußenwandbereich gebildet sein, in dem jeweils eine oder mehrere weitere Wasserauslassöffnungen der Wasserableitstruktur 5 gebildet sind. In Fig. 9 ist dies durch zwei weitere, vierte Wasserauslassöffnungen 22₁, 22₂ an einer der dritten Quaderseite Q3 benachbarten Quaderseite Q4 zwischen der ersten und der zweiten Quaderseite Q1, Q2 stellvertretend für andere mögliche Realisierungen exemplarisch repräsentiert.

Wie die gezeigten und die weiteren oben erläuterten Ausführungsbeispiele deutlich machen, stellt die Erfindung ein Ladegerät und ein diesbezügliches Ladegerätgehäuse mit sehr vorteilhafter Konfiguration hinsichtlich Handhabung, Gebrauchsvariabilität, Funktionalität und Feuchtigkeitsschutz zur Verfügung. Das Ladegerät kann insbesondere zum elektrischen Aufladen von Akkupacks und ähnlichen wiederaufladbaren Batterieeinheiten für handgeführte Garten-und Forstbearbeitungsgeräte sowie andere elektrisch betriebene Handwerkzeuggeräte verwendet werden.

## Patentansprüche

1. Ladegerätgehäuse mit
- einer Bedienseite (1),
- mindestens einem von der Bedienseite (1) her zugänglichen Batterieladeplatz (2),
- einem ersten Gehäuseaußenwandbereich (13) an einer ersten Gehäuseseite (3), die in einer ersten Gebrauchslage (G1) des Ladegerätgehäuses dessen untenliegende Seite bildet,
- einem zweiten Gehäuseaußenwandbereich (14) an einer zur ersten nicht-parallelen zweiten Gehäuseseite (4), die in einer zweiten Gebrauchslage (G2) des Ladegerätgehäuses dessen untenliegende Seite bildet, und
- einer Wasserableitstruktur (5) zum Ableiten von Wasser aus dem Ladegerätgehäuse, wobei die Wasserableitstruktur (5) mindestens eine erste Wasserauslassöffnung (6a₁) in dem ersten Gehäuseaußenwandbereich (13) und mindestens eine zweite Wasserauslassöffnung (7₁) in dem zweiten Gehäuseaußenwandbereich (14) beinhaltet,
**dadurch gekennzeichnet, dass**
- der erste Gehäuseaußenwandbereich (13) von einem erhabenen ersten Mittenbereich (3z) zu mindestens einem tieferliegenden ersten Seitenrandbereich (3a) hin konkav abfallend verläuft und sich mindestens eine (6a₁) der einen oder mehreren ersten Wasserauslassöffnungen in dem mindestens einen tieferliegenden ersten Seitenrandbereich (3a) befindet und/oder
- der zweite Gehäuseaußenwandbereich (14) von mindestens einem erhabenen zweiten Seitenrandbereich (4a) zu einem tieferliegenden zweiten Mittenbereich (4z) hin konvex abfallend verläuft und sich mindestens eine der einen oder mehreren zweiten Wasserauslassöffnungen (7₁) in dem tieferliegenden zweiten Mittenbereich (4z) befindet.

2. Ladegerätgehäuse nach Anspruch 1, weiter **dadurch gekennzeichnet, dass** der mindestens eine erste Seitenrandbereich (3a) einen gegenüber einem angrenzenden, tieferliegenden Wandabschnitt (8t) erhabenen Wandabschnitt (8e) aufweist und sich die mindestens eine (6a₁) dortige erste Wasserauslassöffnung in einem den tieferliegenden Wandabschnitt (8t) mit dem erhabenen Wandabschnitt (8e) verbindenden Wandabschnitt (8s) befindet.

3. Ladegerätgehäuse nach Anspruch 1 oder 2, weiter **dadurch gekennzeichnet, dass** der mindestens eine erste Seitenrandbereich (3a) eine Griffmuldenzone (9) mit einem erhabenen Griffzonenabschnitt (9e) und einem demgegenüber tieferliegenden Griffzonenabschnitt (9t) aufweist und sich mindestens (6c₁) eine der einen oder mehreren ersten Wasserauslassöffnungen in dem tieferliegenden Griffzonenabschnitt (9t) befindet.

4. Ladegerätgehäuse nach einem der Ansprüche 1 bis 3, weiter **dadurch gekennzeichnet, dass** der Batterieladeplatz (2) ein zur Bedienseite (1) hin offenes Batterieschachtgehäuse (10) aufweist und die Wasserableitstruktur (5) mindestens eine dritte Wasserauslassöffnung (11₁) beinhaltet, die aus dem Batterieschachtgehäuse (10) herausführt.

5. Ladegerätgehäuse nach Anspruch 4, weiter **dadurch gekennzeichnet, dass** die mindestens eine dritte Wasserauslassöffnung (11₁, 11₂) aus einer der Bedienseite (1) entgegengesetzten Gehäuseseite (10a) des Batterieschachtgehäuses (10) in einen Gehäuseinnenraum (15) zwischen dem Batterieschachtgehäuse (10) und dem ersten oder dem zweiten Gehäuseaußenwandbereich (13, 14) mündet oder direkt in eine zugeordnete der einen oder mehreren ersten oder zweiten Wasserauslassöffnungen (6d₁, 7₁) mündet.

6. Ladegerätgehäuse nach einem der Ansprüche 1 bis 5, weiter **dadurch gekennzeichnet, dass** es eine zweiteilige Gehäuseschale mit einer Bodengehäuseschale (12a) und einer mit dieser umlaufend verbundenen Deckelgehäuseschale (12b) umfasst, wobei mindestens eine der einen oder mehreren zweiten Wasserauslassöffnungen (7₁) in dem zweiten Gehäuseaußenwandbereich (14) eine Spaltöffnung (17) zwischen den beiden Gehäuseschalen (12a, 12b) beinhaltet.

7. Ladegerätgehäuse nach Anspruch 6, weiter **dadurch gekennzeichnet, dass** mehrere zweite Wasserauslassöffnungen (7₁, 7₂) in dem zweiten Gehäuseaußenwandbereich (14) eine jeweilige Spaltöffnung zwischen den beiden Gehäuseschalen (12a, 12b) beinhalten und entlang einer Trennlinie (12c) der beiden Gehäuseschalen (12a, 12b) voneinander beabstandet sind.

8. Ladegerätgehäuse nach einem der Ansprüche 1 bis 7, weiter **dadurch gekennzeichnet, dass** es quaderförmig ist, wobei eine erste Quaderseite (Q1) die Bedienseite (1) bildet, eine der ersten gegenüberliegende zweite Quaderseite (Q2) die erste Gehäuseseite (3) bildet und eine dritte Quaderseite (Q3) zwischen der ersten und der zweiten Quaderseite (Q1, Q2) die zweite Gehäuseseite (4) bildet.

9. Ladegerät zum elektrischen Laden einer wiederaufladbaren Batterieeinheit, **gekennzeichnet durch** ein Ladegerätgehäuse nach einem der Ansprüche 1 bis 8.

## Claims

1. Charger housing comprising
- an operating side (1),
- at least one battery charging space (2), which is accessible from the operating side (1),
- a first housing outer wall region (13) on a first housing side (3), said first housing side forming, in a first use position (G1) of the charger housing, a bottom side thereof, and
- a second housing outer wall region (14) on a second housing side (4), said second housing side being non-parallel to the first housing side and forming, in a second use position (G2) of the charger housing, a bottom side thereof, and
- a water discharge structure (5) for discharge of water out of the charger housing, wherein the water discharge structure (5) contains at least one first water outlet opening (6a₁) in the first housing outer wall region (13) and at least one second water outlet opening (7₁) in the second housing outer wall region (14),
**characterized in that**
- the first housing outer wall region (13) extends in a concavely descending manner from an elevated first central region (3z) to at least one lower-lying first side edge region (3a), and at least one (6a₁) of the one or more first water outlet openings is situated in the at least one lower-lying first side edge region (3a) and/or
- the second housing outer wall region (14) extends in a convexly descending manner from at least one elevated second side edge region (4a) to a lower-lying second central region (4z), and at least one of the one or more second water outlet openings (7₁) is situated in the lower-lying second central region (4z).

2. Charger housing according to Claim 1, further **characterized in that** the at least one first side edge region (3a) has a wall section (8e) which is elevated in relation to an adjoining lower-lying wall section (8t), and the at least one (6a₁) first water outlet opening there is situated in a wall section (8s) connecting the lower-lying wall section (8t) to the elevated wall section (8e).

3. Charger housing according to Claim 1 or 2, further **characterized in that** the at least one first side edge region (3a) has a grip depression zone (9) with an elevated grip zone section (9e) and with a comparatively lower-lying grip zone section (9t), and at least one (6c₁) of the one or more first water outlet openings is situated in the lower-lying grip zone section (9t).

4. Charger housing according to any one of Claims 1 to 3, further **characterized in that** the battery charging space (2) has a battery compartment housing (10) which is open towards the operating side (1), and the water discharge structure (5) contains at least one third water outlet opening (11₁), which leads out of the battery compartment housing (10).

5. Charger housing according to Claim 4, further **characterized in that** the at least one third water outlet opening (11₁, 11₂) opens out, from a housing side (10a) of the battery compartment housing (10) that is opposite the operating side (1), into a housing interior (15) between the battery compartment housing (10) and the first or the second housing outer wall region (13, 14) or directly into an associated one of the one or more first or second water outlet openings (6d₁, 7₁).

6. Charger housing according to any one of Claims 1 to 5, further **characterized in that** it comprises a two-part housing shell having a base housing shell (12a) and having a cover housing shell (12b), which is connected peripherally to said base housing shell, wherein at least one of the one of more second water outlet openings (7₁) in the second housing outer wall region (14) contains a gap opening (17) between the two housing shells (12a, 12b).

7. Charger housing according to Claim 6, further **characterized in that** multiple second water outlet openings (7₁, 7₂) in the second housing outer wall region (14) contain a respective gap opening between the two housing shells (12a, 12b) and are spaced apart from one another along a separation line (12c) of the two housing shells (12a, 12b).

8. Charger housing according to any one of Claims 1 to 7, further **characterized in that** it is cuboidal, wherein a first cuboid side (Q1) forms the operating side (1), a second cuboid side (Q2), opposite the first cuboid side, forms the first housing side (3), and a third cuboid side (Q3), between the first and second cuboid sides (Q1, Q2), forms the second housing side (4).

9. Charger for electrically charging a rechargeable battery unit, **characterized by** a charger housing according to any one of Claims 1 to 8.

## Revendications

1. Boîtier de chargeur avec
- un côté de commande (1),
- au moins un emplacement (2) de chargement de batterie accessible depuis le côté de commande (1),
- une première zone (13) de paroi extérieure de boîtier sur un premier côté de boîtier (3) qui, dans une première position d'utilisation (G1) du boîtier de chargeur, forme le côté inférieur de celui-ci,
- une deuxième zone (14) de paroi extérieure de boîtier sur un deuxième côté de boîtier (4) non parallèle au premier, qui forme le côté inférieur du boîtier de chargeur dans une deuxième position d'utilisation (G2) de celui-ci, et
- une structure (5) d'évacuation d'eau pour évacuer l'eau du boîtier de chargeur, la structure (5) d'évacuation d'eau comprenant au moins une première ouverture (6a₁) de sortie d'eau dans la première zone (13) de paroi extérieure de boîtier et au moins une deuxième ouverture (7₁) de sortie d'eau dans la deuxième zone (14) de paroi extérieure de boîtier,
**caractérisé en ce que**
- la première zone (13) de paroi extérieure de boîtier s'étend en pente concave depuis une première zone centrale surélevée (3z) vers au moins une première zone de bordure latérale (3a) plus basse et au moins une (6a₁) parmi l'une ou plusieurs des premières ouvertures de sortie d'eau se trouve dans ladite au moins une première zone de bordure latérale (3a) plus basse et/ou
- la deuxième zone (14) de paroi extérieure de boîtier s'étend en pente convexe depuis au moins une deuxième zone de bordure latérale (4a) surélevée jusqu'à une deuxième zone centrale (4z) située plus bas et au moins une parmi l'une ou plusieurs des deuxièmes ouvertures (7₁) de sortie d'eau se trouve dans la deuxième zone centrale (4z) située plus bas.

2. Boîtier de chargeur selon la revendication 1, **caractérisé en outre en ce que** ladite au moins une première zone de bordure latérale (3a) présente une portion de paroi (8e) en relief par rapport à une portion de paroi (8t) adjacente située plus bas, et **en ce que** ladite au moins une (6a₁) première ouverture de sortie d'eau qui est située là se trouve dans une portion de paroi (8s) reliant la portion de paroi (8t) située plus bas à la portion de paroi (8e) en relief.

3. Boîtier de chargeur selon la revendication 1 ou la revendication 2, **caractérisé en outre en ce que** ladite au moins une première zone de bordure latérale (3a) présente une zone de préhension (9) en renfoncement avec une portion de zone de préhension en relief (9e) et une portion de zone de préhension (9t) située plus basse par rapport à celle-ci, et au moins une (6c₁) parmi une ou plusieurs premières ouvertures de sortie d'eau se trouve dans la portion de zone de préhension (9t) située plus bas.

4. Boîtier de chargeur selon l'une des revendications 1 à 3, **caractérisé en outre en ce que** l'emplacement (2) de chargement de batterie présente un boîtier (10) formant logement de batterie ouvert vers le côté de commande (1), et la structure (5) d'évacuation d'eau comprend au moins une troisième ouverture (11₁) de sortie d'eau qui débouche hors du boîtier (10) formant logement de batterie.

5. Boîtier de chargeur selon la revendication 4, **caractérisé en outre en ce que** ladite au moins une troisième ouverture de sortie d'eau (11₁, 11₂) débouche depuis un côté de boîtier (10a) du boîtier (10) formant logement de batterie opposé au côté de commande (1) dans un espace intérieur (15) de boîtier entre le boîtier (10) formant logement de batterie et la première ou la deuxième zone de paroi extérieure (13, 14) de boîtier, ou débouche directement dans une ouverture associée parmi lesdites une ou plusieurs première ou deuxième ouvertures de sortie d'eau (6d₁, 7₁).

6. Boîtier de chargeur selon l'une des revendications 1 à 5, **caractérisé en outre en ce qu'**il comprend une coque de boîtier en deux parties avec une coque de boîtier de fond (12a) et une coque de boîtier de couvercle (12b) reliée à celle-ci de manière périphérique, au moins une parmi lesdites une ou plusieurs deuxièmes ouvertures (7₁) de sortie d'eau dans la deuxième zone (14) de paroi extérieure de boîtier contenant une ouverture (17) en forme de fente entre les deux coques de boîtier (12a, 12b) .

7. Boîtier de chargeur selon la revendication 6, **caractérisé en outre en ce que** plusieurs deuxièmes ouvertures (7₁, 7₂) de sortie d'eau dans la deuxième zone (14) de paroi extérieure de boîtier comprennent une ouverture en forme de fente respective entre les deux coques de boîtier (12a, 12b) et sont espacées les unes des autres le long d'une ligne de séparation (12c) des deux coques de boîtier (12a, 12b).

8. Boîtier de chargeur selon l'une des revendications 1 à 7, **caractérisé en outre en ce qu'**il est parallélépipédique, un premier côté parallélépipédique (Q1) formant le côté de commande (1), un deuxième côté parallélépipédique (Q2) opposé au premier formant le premier côté de boîtier (3) et un troisième côté parallélépipédique (Q3) entre le premier et le deuxième côté parallélépipédique (Q1, Q2) formant le deuxième côté de boîtier (4).

9. Chargeur pour charger électriquement une unité de batterie rechargeable, **caractérisé par** un boîtier de chargeur selon l'une des revendications 1 à 8.
